# EUROPÄISCHE PATENTSCHRIFT

(11) **EP 1 168 006 B1**
(45) Veröffentlichungstag und Bekanntmachung des Hinweises auf die Patenterteilung: **05.07.2006**
(21) Anmeldenummer: 01112204.1
(22) Anmeldetag: 18.05.2001
(51) Int. Cl.: G02B 5/09, G02B 7/182, B29D 11/00, G02B 7/18, C25C 1/00

(54) **Verfahren zum Verbinden einer Vielzahl von optischen Elementen mit einem Grundkörper**
Method for bonding a plurality of optical elements to a base
Méthode d'attachement de plusieurs éléments optiques à une base

(30) Priorität: 21.06.2000 DE 10030495
(43) Veröffentlichungstag der Anmeldung: 02.01.2002
(73) Patentinhaber: Carl Zeiss SMT AG, 73447 Oberkochen (DE)
(72) Erfinder: Melzer, Frank, Dipl.-Ing., 73469 Utzmemmingen (DE); Bingel, Ulrich, Dipl.-Ing., 73457 Lauterburg (DE)
(74) Vertreter: Lorenz, Werner

(56) Entgegenhaltungen:
- EP-A- 0 143 014
- EP-A- 0 624 807
- DD-A- 204 320
- DE-A- 2 637 735
- DE-A- 19 649 993
- DE-A- 19 735 831
- DE-B- 1 146 667
- GB-A- 2 010 523
- US-A- 4 277 141

## Beschreibung

Die Erfindung betrifft ein Verfahren zum Herstellen eines Facettenspiegels aus einer Vielzahl von Spiegelelementen z.B. zur Strahlmischung und Feldabbildung für ein EUV-Beleuchtungssystem, die auf einem Grundkörper positioniert sind. Die Erfindung betrifft auch einen nach dem Verfahren hergestellten Facettenspiegel.

Aus der US-PS 4 277 141 ist ein Verfahren bekannt, wonach ein Multifacettenspiegel in mehreren Schritten hergestellt wird, nämlich in einem ersten Schritt werden Einzelspiegel geschaffen, anschließend werden die Einzelspiegel fixiert und ausgerichtet und über einen Klebstoff mit einem Tragkörper verbunden.

In der US-PS 4 195 913 ist ein Facettenspiegel beschrieben, bei dem eine Vielzahl von Einzelspiegeln auf einer sphärischen Trägerstruktur angeklebt oder angeschraubt wird.

In der DE 197 35 831 A1 ist eine Optikfassung für ein Optikbauteil beschrieben, wobei ein Innenteil mit einem Außenrahmen durch eine Mehrzahl von Federgelenkbalken verbunden ist. Die Federgelenkbalken sind galvanoplastisch hergestellt.

Die DD 204 320 zeigt eine Anordnung von Linsen, wobei die mechanischen Kontaktflächen mit einem physikalisch aufgebrachten und elektrisch leitenden Trägermaterial versehen sind, welches kontaktiert und mit Metallschichten galvanisch belegt ist. Die DE 196 49 993 A1 betrifft ein Verfahren zur Herstellung eines Polygonspiegels, wobei auf einen Grundkörper eine galvanische Beschichtung auf jede der Polygonflächen aufgebracht wird, welche die Spiegelflächen bilden.

Der vorliegenden Erfindung liegt die Aufgabe zugrunde, ein Verfahren zum Herstellen eines Facettenspiegels mit Spiegelelementen der eingangs erwähnten Art zu schaffen, wobei die Vielzahl der Spiegelelemente mit hoher Genauigkeit, insbesondere bezüglich Position und Winkligkeit, auf dem Grundkörper angeordnet werden können, so dass z.B. Strahlmischungen und Feldabbildungen mit hoher Präzision erfolgen können.

Der vorliegenden Erfindung liegt auch die Aufgabe zugrunde, einen Facettenspiegel mit einer Vielzahl von einzelnen optischen Spiegelelementen zu bilden, der eine homogene Beleuchtungsverteilung bzw. homogene Ausleuchtung und eine sehr exakte Strahlmischung und Feldabbildung erzeugt.

Erfindungsgemäß wird die Aufgabe durch das im kennzeichnenden Teil von Anspruch 1 genannte Verfahren gelöst.

Ein nach dem erfindungsgemäßen Verfahren hergestellter Facettenspiegel ist in Anspruch 10 beschrieben.

Durch das erfindungsgemäße Verfahren können eine Vielzahl einzelner optischer Elemente, die völlig identisch ausgebildet sein können, auf relativ einfache Weise und sehr präzise durch den Galvanisierungsprozeß miteinander und mit einem Grundkörper verbunden werden. Da durch den Galvanisierungsprozeß exakt nachvollziehbare Verhältnisse geschaffen werden, läßt sich auf diese Weise z.B. ein Facettenspiegel bilden, der die homogene Ausleuchtung eines Feldes ermöglicht, womit eine entsprechend gute Strahlmischung und eine exakte Feldabbildung möglich werden.

Mit dem erfindungsgemäßen Verfahren lassen sich eine Strahlmischung bzw. eine Beleuchtung erreichen, die die nachteilige höhere Lichtintensität im mittleren Bereich beseitigt. Dies ist insbesondere in der optischen Lithographie mit einem EUV-Beleuch-tungssystem von Vorteil, wobei man z.B. auf dem Reticle (Maske) eine möglichst große homogen ausgeleuchtete Fläche haben möchte.

Die Realisierung des erfindungsgemäßen Verfahrens ist durch zwei Fertigungsprinzipien möglich:
1. Die optischen Elemente können durch ein galvanoplastisches Fügen mit dem Grundkörper verbunden werden, wobei auch der Grundkörper galvanisch abgeformt werden kann.
   Bei einer galvanischen Abformung des Grundkörpers wird dieser so geschaffen, daß die Position und Lage der Facetten, nicht jedoch deren Oberflächengüte, auf dem Tragkörper enthalten ist. Die erforderliche Oberflächengüte wird dann durch die optischen Elemente, z.B. Spiegelelemente, realisiert, die nach der Belegung auf den Grundkörper durch ein galvanisches Zusammenwachsen mit diesem verbunden werden. Durch die galvanische Verbindung wird nicht nur eine präzise, vollflächige und damit sehr exakte Positionierung und Verbindung erreicht, sondern auch eine sehr gute Wärmeleitung zur schnellen Wärmeabfuhr von den Spiegelelementen in den Grundkörper.
2. Auf einer Hilfsstruktur, die die Negativform des herzustellenden optischen Teiles, z.B. eines Facettenspiegels, darstellt, werden die optischen Elemente z.B. durch einen Kleber oder ein Harz fixiert, wobei bei der Herstellung eines Facettenspiegels aus Spiegelelementen deren verspiegelten Seiten zur Hilfsstruktur gerichtet sind. Durch die Hilfsstruktur wird dabei die exakte Position und Ausrichtung der optischen Elemente definiert. Durch diese Art der Fixierung werden auch die zur Hilfsstruktur gerichteten optischen Flächen, wie z.B. die Spiegelflächen, bei dem nachfolgenden Galvanisierungsprozeß vor Verunreinigungen geschützt.
   Sobald alle Elemente in Position und Lage gebracht sind, wird die komplette Einheit in einem Bade kathodisch geschaltet und die optischen Elemente werden in einen sich aufbauenden bzw. aufwachsenden Körper eingebunden.
   Bei Verwendung von Linsen als optische Elemente werden diese an einer der optischen Flächen fixiert. Die zweite optische Fläche muß in diesem Falle dann noch separat vor Verunreinigungen geschützt werden. Linsen oder nichtleitende Spiegelelemente müssen vorher durch eine entsprechende Beschichtung elektrisch leitend gemacht werden.

In vorteilhaften Weiterbildungen der Erfindung kann vorgesehen sein, daß in den aufwachsenden Körper während des Galvanisierungsprozesses noch Kühl- und/oder Versteifungseinrichtungen eingebaut werden.

Durch das erfindungsgemäße Verfahren wird praktisch ein monolithischer Körper gebildet, der durch einen guten Wärmeübergang der einzelnen optischen Elemente zum Grundkörper eine effiziente Kühlung des optischen Elements ermöglicht.

Weitere vorteilhafte Ausgestaltungen und Weiterbildungen der Erfindung ergeben sich aus den Unteransprüchen und aus den nachfolgend anhand der Zeichnung prinzipmäßig beschriebenen Ausführungsbeispielen.

Es zeigt:
- Figur 1: Prinzipdarstellung eines in einem EUV-Beleuchtungssystem für die Mikrolithographie angeordneten erfindungsgemäßen Facettenspiegels,
- Figur 2: ein erstes Herstellungsverfahren für einen Facettenspiegel,
- Figur 3: ein zweites Herstellungsverfahren für einen Facettenspiegel, und
- Figur 4: einen Grundkörper für einen Facettenspiegel mit Versteifungen in Wabenstruktur und mit Kühlkanälen.

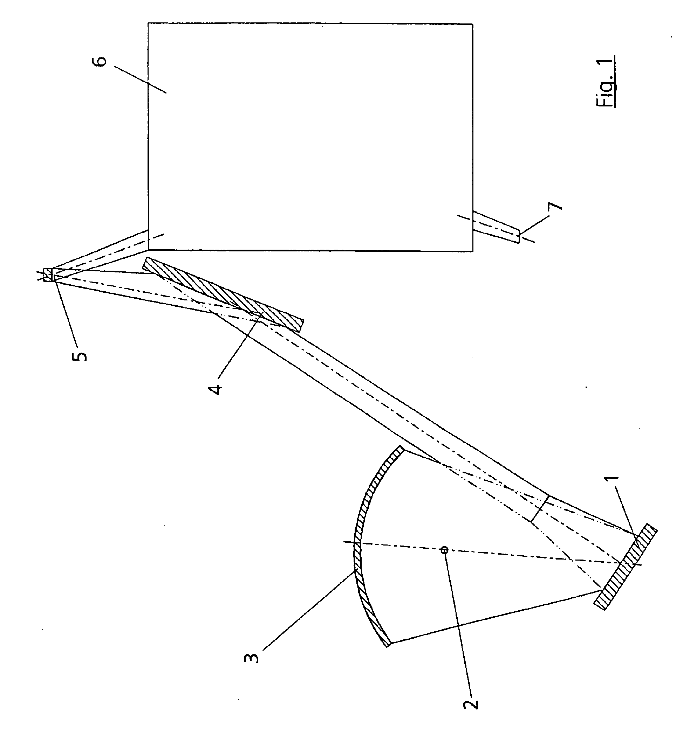

Nachfolgend wird ein Verfahren zur Herstellung eines Facettenspiegels und ein nach dem Verfahren hergestellter Facettenspiegel beispielsweise beschrieben. Grundsätzlich ist das Verfahren jedoch auch zum Verbinden bzw. Zusammenfügen von anderen optischen Elementen, wie z.B. Linsen und Linsenarrays, geeignet. In der Figur 1 ist die Verwendung eines Facettenspiegels 1 in einem Beleuchtungssystem für die EUV-Lithographie dargestellt. Das Licht einer Quelle 2, z.B. eines Lasers, wird über einen Kollektorspiegel 3 auf den Facettenspiegel 1 geworfen, wo es mit der gewünschten gleichmäßigen Ausleuchtung über einen Umlenkspiegel 4 einem Reticle (Maske) 5 zugeführt wird. Das Muster des Reticles 5 wird über ein nicht näher dargestelltes Projektionsobjektiv 6 einem Wafer 7 zur Abbildung des Bildes vom Reticle 5 zugeleitet.

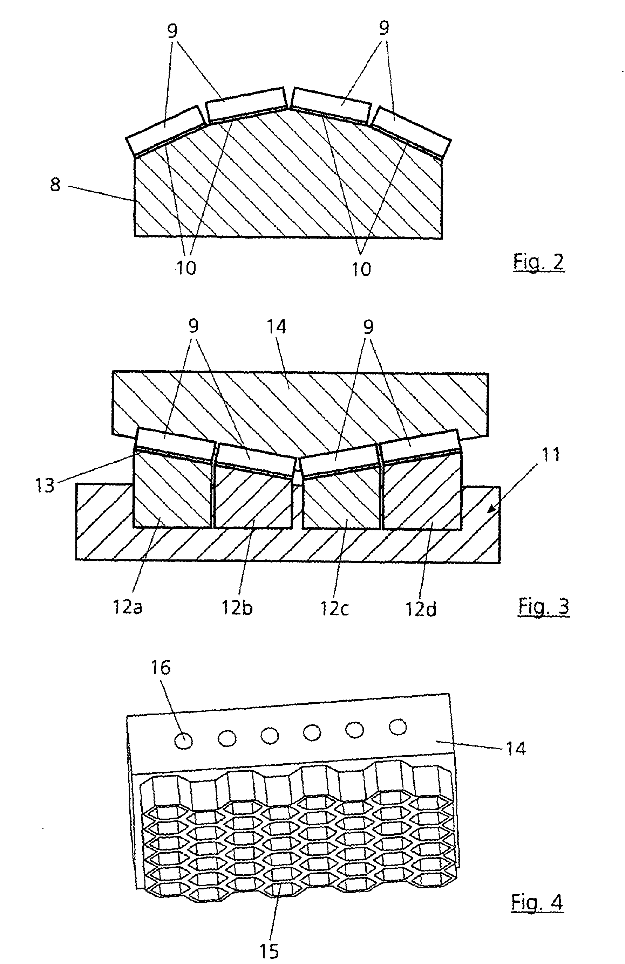

Die Herstellung des Facettenspiegles 1 mit entsprechend hoher Präzision und homogener bzw. wunschgemäßer Ausleuchtung erfolgt gemäß Figur 2 auf einem Grundkörper 8. Der Grundkörper 8 kann z.B. auf galvanische Weise abgeformt sein, wobei dessen Funktionsfläche bezüglich Krümmung, Position und Lage den Forderungen entspricht, die an den fertigen Facettenspiegel 1 gestellt werden. Lediglich die Oberflächengüte fehlt noch. Die Oberflächengüte wird nun durch einzelne Spiegelelemente 9 als optische Elemente realisiert.

Bei der vorliegenden Erfindung werden in Abwandlung einer normalen Galvanoformung eine Vielzahl von Spiegelelementen, z.B. 200 bis 300 Stück, vorab durch einen herkömmlichen Fertigungsprozeß, wie z.B. fräsen, schleifen, polieren, hergestellt. Eine Vielzahl von gleichen Spiegelelementen wird anschließend auf dem Grundkörper 8 in Position und Ausrichtung gebracht und dann durch einen folgenden Galvanisierungsprozeß miteinander verbunden. Auf diese Weise ergibt sich am Ende ein Facettenspiegel als praktisch ein einziges monolithisches Teil in äußerst präziser Ausgestaltung.

Durch die Herstellung vieler gleicher Spiegelelemente wird die Herstellung eines Facettenspiegels weiterhin auch erleichtert, vereinfacht und kostengünstig gestaltet. Schlechte Qualitäten von Spiegelelementen können vorher ausgesondert werden bzw. man kann eine Auswahl von Spiegelelementen 9 treffen, die identisch oder nahezu identisch sind, insbesondere bezüglich ihrer optischen Eigenschaften.

Galvanisierungsprozesse sind allgemein bekannt, weshalb hier nicht näher darauf eingegangen wird. Grundsätzlich erfolgt dies dadurch, daß die Spiegelelemente 9 auf dem Grundkörper 8 in ihre Position gebracht werden und das ganze dann in einem elektrolytischen Bad kathodisch geschaltet wird und als Anode das gewünschte Material, z.B. Cu oder Ni, verwendet wird, so daß die Teile zu einer Einheit zusammenwachsen können. Auf diese Weise kann man z.B. das Anwachsen einer Kupferschicht mit beliebiger Dicke erreichen.

Als Materialien für die Spiegel kommen prinzipiell alle leitenden Materialien oder Materialien, die durch Beschichtung leitend gemacht werden können, in Frage. Für EUV-Beleuchtungssysteme sollte außerdem noch die Polierbarkeit auf die geforderte Oberflächengüte (0,2 bis 0,3 nm RMS) gewährleistet sein. Außerdem sollte das Material gute Wärmeleitfähigkeiten besitzen. Aus den vorstehend genannten Gründen wird man im allgemeinen Kupfer mit Nickel beschichtet als Facettenmaterial verwenden.

Die auf den Grundkörper 8 aufgelegten Spiegelelemente 9 werden durch ein galvanoplastisches Fügen mit dem Grundkörper 8 verbunden, wie dies durch eine Zwischenschicht 10 zwischen Spiegelelementen 9 und dem Grundkörper 8 angedeutet ist.

Alternativ dazu kann gemäß Figur 3 eine Hilfsstruktur 11 zur Positionierung der Spiegelelemente 9 vorgesehen werden. Die Hilfsstruktur kann zur genaueren Anpassung aus mehreren Einzelstempeln 12a, 12b, 12c ... zusammengesetzt sein, die zusammen eine Oberfläche in Negativform für den herzustellenden Facettenspiegel bilden und bei einer sphärischen Fläche entsprechend auf Abstand zueinander liegen bzw. Zwischenräume aus Platzgründen vorsehen.

Die Spiegelelemente werden, z.B. durch einen Kleber oder ein Harz 13, mit ihrer verspiegelten Seite auf der Hilfsstruktur 11 fixiert. Durch diese Art von Ausrichtung und der Fixierung werden die Spiegelflächen der Spiegelelemente 9 beim nachfolgenden Galvanisierungsprozeß vor Verunreinigungen geschützt. Sind alle Spiegelelemente 9 in Position und Lage gebracht, wird die komplette Vorrichtung in einem elektrolytischen Bad kathodisch geschaltet und die Elemente werden in einem aufwachsenden Körper, der damit eine Tragstruktur 14 für die einzelnen Spiegelelemente 9 bildet, miteinander verbunden bzw. in den entstehenden Körper eingebunden.

Bei einer Bildung von Linsenarrays werden ebenfalls die einzelnen Linsen jeweils mit einer der optischen Flächen auf der Hilfsstruktur 11 fixiert. Die zweiten optischen Flächen müssen dann noch separat vor Verunreinigungen geschützt werden. Linsen oder nicht leitende Spiegelelemente müssen vorher durch eine entsprechende Beschichtung elektrisch leitend gemacht werden.

Nach Fertigstellung einer genügend starken Tragstruktur 14, können anschließend noch oder auch parallel mit dem Aufwachsen Versteifungsstrukturen auf galvanischem Wege eingebaut werden oder man läßt sie entsprechend aufwachsen. In der Figur 4 ist zur Versteifung der Tragstruktur 14 eine Wabenstruktur 15 (ohne Spiegelelemente) dargestellt. Zusätzlich ist aus der Figur 4 ersichtlich, daß die Tragstruktur 14 mit einem Kühlsystem in Form von Kühlkanälen 16 versehen sein kann.

Die Kühlkanäle 16 können während des Galvanisierungsprozesses eingeformt werden. Hierzu ist es lediglich erforderlich, daß man entsprechende Wachseinlagen in Schlangenform vorsieht, welche anschließend ausgeschmolzen werden.

Eine weitere Lösung kann darin bestehen, daß man ein Kupferrohr schlangenförmig auflegt und dieses dann beim Galvanisierungsprozeß einwachsen läßt. Auf diese Weise erhält man dann einen sehr guten Wärmeübergang aufgrund einer metallischen Verbindung.

Selbstverständlich sind auch Kombinationen möglich. Gleiches gilt z.B. für die Ausbildung der Tragstruktur 14 mit der Wabenstruktur 15, in die ebenfalls Kühlkanäle 16 eingeformt sein können bzw. wobei auch die Waben selbst zur Kühlung dienen können.

## Patentansprüche

1. Verfahren zum Herstellen eines Facettenspiegels, z.B. zur Strahlmischung und Feldabbildung für ein EUV-Beleuchtungssystem, **dadurch gekennzeichnet, dass** eine Vielzahl von Spiegelelementen (9) entweder auf einem Grundkörper (8) positioniert und anschließend durch galvanoplastisches Fügen mit dem Grundkörper (8) verbunden werden oder auf einer Hilfsstruktur (11) positioniert und auf ihren von der Hilfsstruktur (11) abgewandten Rückseiten unter Bildung einer Tragstruktur (14) als Grundkörper, der galvanoplastisch aufwächst, untereinander verbunden werden.

2. Verfahren nach Anspruch 1, **dadurch gekennzeichnet, dass** der Grundkörper (8) galvanisch abgeformt wird.

3. Verfahren nach Anspruch 1, **dadurch gekennzeichnet, dass** die aufgewachsene Tragstruktur (14) mit Versteifungen versehen wird.

4. Verfahren nach Anspruch 3, **dadurch gekennzeichnet, dass** die Versteifungen (15) auf galvanischem Wege integriert werden.

5. Verfahren nach Anspruch 1, **dadurch gekennzeichnet, dass** die Tragstruktur (14) als Wabenstruktur (15) ausgeführt wird.

6. Verfahren nach einem der Ansprüche 1 oder 3 bis 5, **dadurch gekennzeichnet, dass** die Tragstruktur (14) mit Kühlkanälen (16) versehen wird.

7. Verfahren nach Anspruch 6, **dadurch gekennzeichnet, dass** die Kühlkanäle (16) beim Galvanisierungsprozess durch Kerne mit eingeformt werden, welche anschließend entfernt werden.

8. Verfahren nach Anspruch 6, **dadurch gekennzeichnet, dass** die Kühlkanäle (16) durch eingelegte Rohre gebildet werden, die bei dem Galvanisierungsprozess einwachsen.

9. Verfahren nach Anspruch 1, **dadurch gekennzeichnet, dass** die Hilfsstruktur (11) aus mehreren Stempeln (12a,12b,..) mit dazwischen liegenden Abstands- oder Positionshaltern gebildet wird.

10. Facettenspiegel zur Strahlmischung und Feldabbildung für ein Beleuchtungssystem, wobei eine Vielzahl von Spiegelelementen auf einem Grundkörper angeordnet sind, **dadurch gekennzeichnet, dass** die Spiegelelemente (9) durch galvanisches Fügen mit dem Grundkörper (8,14) verbunden sind.

11. Facettenspiegel nach Anspruch 10, **dadurch gekennzeichnet, dass** der Grundkörper (8) galvanisch abgeformt ist.

12. Facettenspiegel nach Anspruch 10, **dadurch gekennzeichnet, dass** die Spiegelelemente (9) auf ihren Rückseiten mit einer Tragstruktur (14) als Grundkörper verbunden sind, mit dem sie galvanoplastisch aufgewachsen sind.

13. Facettenspiegel nach Anspruch 12, **dadurch gekennzeichnet, dass** die Tragstruktur (14) mit Versteifungen versehen ist.

14. Facettenspiegel nach Anspruch 13, **dadurch gekennzeichnet, dass** die Versteifungen auf galvanischem Wege hergestellt sind.

15. Facettenspiegel nach Anspruch 14, **dadurch gekennzeichnet, dass** die Versteifungen als Wabenstruktur (15) ausgeführt sind.

16. Facettenspiegel nach einem der Ansprüche 12 bis 15, **dadurch gekennzeichnet, dass** die Tragstruktur (14) mit Kühlkanälen (16) versehen ist.

## Claims

1. Method for producing a multifaceted mirror, for example for beam mixing and field imaging for an EUV illumination system, **characterised in that** a plurality of mirror elements (9) are positioned either on a base body (8) and then connected to the base body (8) by galvanoplastic joining, or on an auxiliary structure (11) and are connected to one another on their reverse sides facing away from the auxiliary structure (11) through the formation by galvanoplastic deposition of a support structure (14) as the base body.

2. Method according to claim 1, **characterised in that** the base body (8) is moulded galvanically.

3. Method according to claim 1, **characterised in that** the deposited support structure (14) is provided with stiffening elements.

4. Method according to claim 3, **characterised in that** the stiffening elements (15) are integrated by galvanic means.

5. Method according to claim 1, **characterised in that** the support structure (14) is embodied in the form of a honeycomb structure (15).

6. Method according to any one of claims 1 or 3 to 5, **characterised in that** the support structure (14) is provided with cooling passages (16).

7. Method according to claim 6, **characterised in that** the cooling passages (16) are moulded-in during the galvanizing process by means of cores which are subsequently removed.

8. Method according to claim 6, **characterised in that** the cooling passages (16) are formed by inserted tubes which are incorporated integrally during the galvanizing process.

9. Method according to claim 1, **characterised in that** the auxiliary structure (11) is formed using a plurality of dies (12a, 12b,...) having spacers or positioners located therebetween.

10. Multifaceted mirror for beam mixing and field imaging for an illumination system, a plurality of mirror elements being arranged on a base body, **characterised in that** the mirror elements (9) are connected to the base body (8, 14) by galvanic joining.

11. Multifaceted mirror according to claim 10, **characterised in that** the base body (8) is moulded galvanically.

12. Multifaceted mirror according to claim 10, **characterised in that** the mirror elements (9) are connected on their reverse sides to a support structure (14) acting as the base body, with which they are integrated galvanoplastically.

13. Multifaceted mirror according to claim 12, **characterised in that** the support structure (14) is provided with stiffening elements.

14. Multifaceted mirror according to claim 13, **characterised in that** the stiffening elements are produced by galvanic means.

15. Multifaceted mirror according to claim 14, **characterised in that** the stiffening elements are embodied in the form of a honeycomb structure (15).

16. Multifaceted mirror according to any one of claims 12 to 15, **characterised in that** the support structure (14) is provided with cooling passages (16).

## Revendications

1. Procédé pour fabriquer un miroir à facettes, par exemple pour le mélange de faisceaux et la reproduction d'un champ pour un système d'éclairage EUV, **caractérisé en ce que** plusieurs éléments de miroir (9) sont, soit positionnés sur un corps de base (8) et ensuite liés au corps de base (8) par assemblage galvanoplastique, soit positionnés sur une structure auxiliaire (11) et liés les uns aux autres, par leurs faces dorsales éloignées de la structure auxiliaire (11) avec formation d'une structure porteuse (14) constituant le corps de base qui se forme par croissance galvanoplastique.

2. Procédé selon la revendication 1, **caractérisé en ce que** le corps de base (8) est formé par moulage galvanoplastique.

3. Procédé selon la revendication 1, **caractérisé en ce que** la structure porteuse (14) formée par croissance est pourvue de renforcements.

4. Procédé selon la revendication 3, **caractérisé en ce que** les renforcements (15) sont intégrés par voie galvanoplastique.

5. Procédé selon la revendication 1, **caractérisé en ce que** la structure porteuse (14) est réalisée sous la forme d'une structure à nid d'abeilles (15).

6. Procédé selon l'une des revendications 1 ou 3 à 5, **caractérisé en ce que** la structure porteuse (14) est pourvue de canaux de refroidissement (16).

7. Procédé selon la revendication 6, **caractérisé en ce que**, lors du processus de galvanoplastie, les canaux de refroidissement (16) sont moulés au moyen de noyaux qui sont retirés par la suite.

8. Procédé selon la revendication 6, **caractérisé en ce que** les canaux de refroidissement (16) sont formés par des tubes insérés qui s'intègrent par croissance lors du processus de galvanisation.

9. Procédé selon la revendication 1, **caractérisé en ce que** la structure auxiliaire (11) est formée de plusieurs piliers (12a, 12b, ...) pourvus d'éléments de maintien de l'écartement ou de la position situés entre ces piliers.

10. Miroir à facettes pour le mélange de faisceaux et la formation d'images de champ pour un système d'éclairage, dans lequel plusieurs éléments de miroir sont disposés sur un corps de base, **caractérisé en ce que** les éléments de miroir (9) sont liés au corps de base (8, 14) par assemblage galvanoplastique.

11. Miroir à facettes selon la revendication 10, **caractérisé en ce que** le corps de base (8) est moulé par voie galvanoplastique.

12. Miroir à facettes selon la revendication 10, **caractérisé en ce que** les éléments de miroir (9) sont liés par leurs faces dorsales à une structure porteuse (14) constituant un corps de base avec lequel ils sont liés par croissance galvanoplastique.

13. Miroir à facettes selon la revendication 12, **caractérisé en ce que** la structure porteuse (14) est pourvue de renforcements.

14. Miroir à facettes selon la revendication 13, **caractérisé en ce que** les renforcements sont produits par voie galvanoplastique.

15. Miroir à facettes selon la revendication 14, **caractérisé en ce que** les renforcements sont réalisés sous la forme d'une structure à nid d'abeilles (15).

16. Miroir à facettes selon la revendication 12 à 15, **caractérisé en ce que** la structure porteuse (14) est pourvue de canaux de refroidissement (16).
